# EUROPEAN PATENT APPLICATION

(11) **EP 1 737 036 A2**
(43) Date of publication of application: **27.12.2006**
(21) Application number: 06012324.7
(22) Date of filing: 14.06.2006
(51) Int. Cl.: H01L 23/485, H01L 21/60

(54) **Semiconductor device and manufacturing method of the same**

(30) Priority: 15.06.2005 JP 2005174921
(71) Applicant: Sanyo Electric Co., Ltd, Moriguchi-city Osaka (JP)
(72) Inventor: Morita, Yuichi, Ora-gun, Gunma 370-0533 (JP); Ishibe, Shinzo, Ora-gun, Gunma 370-0536 (JP); Noma, Takashi, Ota-shi, Gunma 373-0815 (JP); Otsuka, Hisao, Ora-machi, Ora-gun Gunma 370-0603 (JP); Takao, Yukihiro, Ota-shi Gunma 370-0311 (JP); Kanamori, Hiroshi, Tama-shi Tokyo 206-0041 (JP)
(74) Representative: Glawe, Delfs, Moll

(57) **Abstract**

The invention provides a CSP type semiconductor device with high reliability.

The semiconductor device includes a pad electrode (4) formed on a semiconductor substrate (1) with insulation films (2, 3) interposed therebetween, a plating layer (7) formed on the pad electrode (4), a conductive terminal (9) formed on the plating layer and electrically connected with the pad electrode (4), and a first passivation film (5) covering the insulation films (2, 3) and a side end portion of the pad electrode (4), in which an exposed portion of the pad electrode (4) that causes corrosion is covered by forming a second passivation film (10) so as to cover the first passivation film (5), the plating layer (7), and a portion of a sidewall of the conductive terminal (9).

## Description

### Field of the Invention:

The invention relates to a CSP type semiconductor device with high reliability and a manufacturing method thereof.

### Description of the Related Art:

CSP (Chip Size Package) has received attention as a new packaging technology in recent years. The CSP means a small package having almost the same outside dimensions as those of a semiconductor die packaged in it.

Conventionally, a BGA (Ball Grid Array) type semiconductor device has been known as a kind of CSP. Ball-shaped conductive terminals are provided in this BGA type semiconductor device, being electrically connected with pad electrodes on a semiconductor substrate.

When this BGA type semiconductor device is mounted on electronic equipment, a semiconductor die is electrically connected with an external circuit on a printed circuit board by compression bonding of the conductive terminals to wiring patterns on the printed circuit board.

Such a BGA type electronic device has advantages in providing a large number of conductive terminals and in reducing size over other CSP type semiconductor devices such as SOP (Small Outline Package) and QFP (Quad Flat Package), which have lead pins protruding from their sides. Therefore, the BGA type electronic device is broadly used as an image sensor chip for a digital camera incorporated into a mobile telephone or the like, for example.

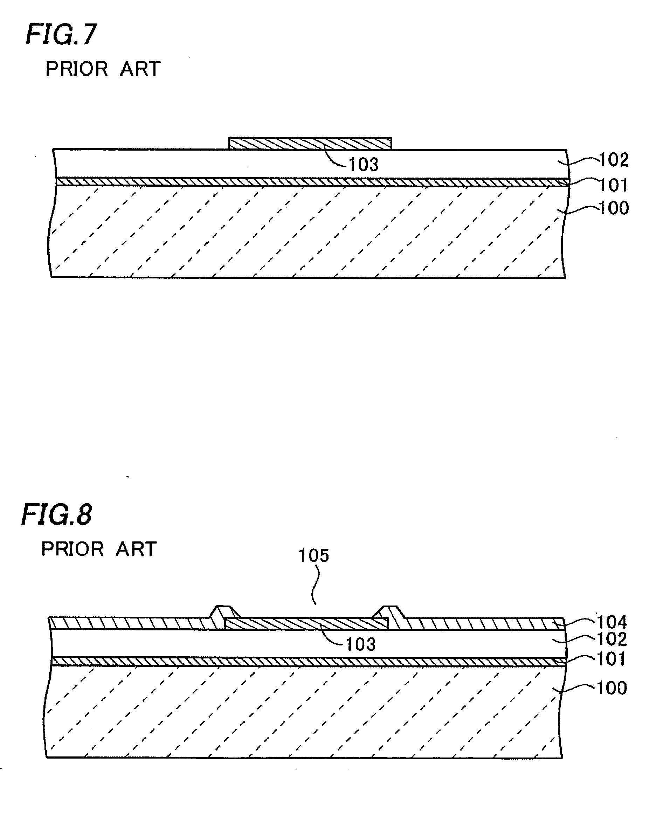

Hereafter, the conventional BGA type semiconductor device will be described using figures (Figs. 7 to 10). Figs. 7 to 10 show cross-sectional views in process order.

First, a silicon oxide film 101 and an interlayer insulation film 102 (a polyimide type resin film, a PSG film, or the like) are formed on a semiconductor substrate 100 made of silicon (Si) or the like as shown in Fig. 7.

A metal layer (aluminum layer) is then formed on the interlayer insulation film 102 and patterned using a mask (not shown) to form a pad electrode 103 on the interlayer insulation film 102.

Next, a passivation film 104 made of solder resist or the like is formed on the front side of the semiconductor substrate 100 including on the pad electrode 103, and exposure and development are performed to the passivation film 104, thereby forming an opening 105 exposing a predetermined surface of the pad electrode 103 as shown in Fig. 8.

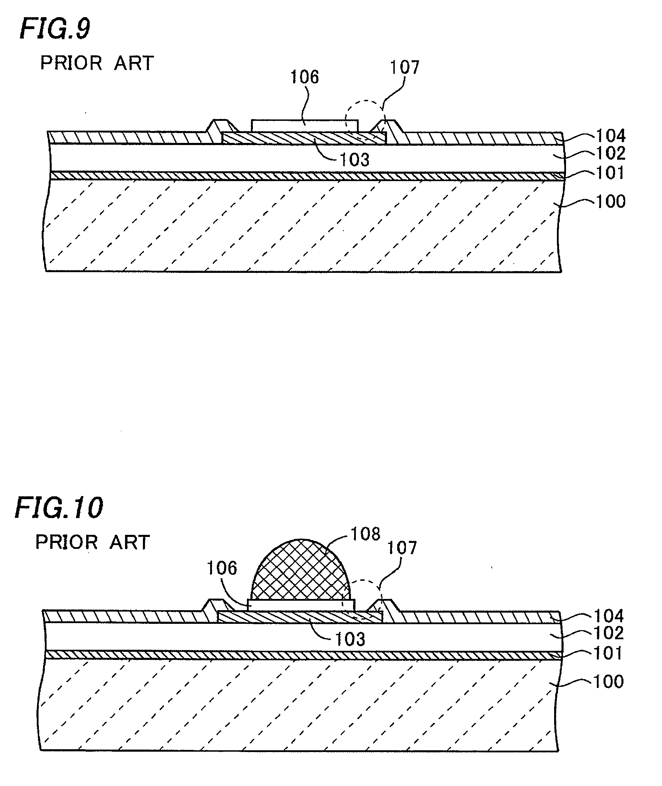

Then, a plating layer 106 having a layered structure of nickel (Ni) and gold (Au) is formed on the pad electrode 103 exposed in the opening 105 by an electrolytic plating method or an electroless plating method as shown in Fig. 9.

A portion near an end portion of the pad electrode 103 is not covered with the plating layer 106, leaving an exposed portion 107. There can be various causes of the formation of this exposed portion 107. One example is that residues of the passivation film 104 are easy to remain on its sidewall (patterned surface) when the opening 105 is formed due to filler (additive) or the like added to the passivation film 104 for preventing the passivation film 104 from warping, and the residue makes the sidewall uneven, so that the plating layer 106 hardly adheres to the sidewall. It is noted that the exposed portion 107 means a portion exposing the pad electrode 103 between the passivation film 104 and the plating layer 106.

Next, a solder ball is fixed to a predetermined region of the plating layer 106 by an electrolytic plating method or an electroless plating method, thereby forming a conductive terminal 108 as shown in Fig. 10.

It is possible to form the conductive terminal 108 by screenprinting solder and reflowing the solder by a heat treatment (solder bump).

The relevant technology is disclosed in Japanese Patent Application Publication No. 2000-299406.

In the described conventional BGA type semiconductor device, however, a substance such as moisture, chemicals, a corrosive gas, metal ions, or the like that causes corrosion infiltrates through the exposed portion 107 to corrode the pad electrode 103 and reduces the reliability of the semiconductor device.

It is an object of this invention to provide on improved semiconductor substrate and a manufacturing method of the same.

### SUMMARY OF THE INVENTION

The solution according to this invention resides in the features of the independent claims and preferably in those of the dependent claims.

The invention provides a semiconductor device that includes a semiconductor substrate, an insulation film disposed on the substrate, a pad electrode disposed on the insulation film, a first passivation film disposed on the insulation film and having an opening above the pad electrode so that an edge portion of the pad electrode is covered by the first passivation film, a plating layer disposed on the pad electrode in the opening, a conductive terminal disposed on the plating layer and electrically connected with the pad electrode, and a second passivation film disposed on the first passivation film and in contact with the conductive terminal.

The invention also provides a method of manufacturing a semiconductor device. The method includes providing a semiconductor substrate having an insulation film disposed thereon and an pad electrode disposed on the insulation film, forming on the insulation film a first passivation film covering an edge portion of the pad electrode, forming a plating layer on the pad electrode by an electrolytic plating method or an electroless plating method, forming a conductive terminal on the plating layer, and forming on the first passivation film a second passivation film so as to be in contact with the conductive terminal and to fill a gap between an edge portion of the plating layer and an edge portion of the first passivation film.

By virtue of the invention the second passivation film covers the exposed portion of the pad electrode between the plating layer and the first passivation film. This prevents moisture, chemicals, or the like from infiltrating into the pad electrode through the exposed portion, so that the pad electrode can be prevented from corroding and thus the reliability of the semiconductor device can be enhanced.

### BRIEF DESCRIPTION OF THE DRAWINGS

Figs. 1 to 5 are cross-sectional views for explaining a semiconductor device of an embodiment of the invention and its manufacturing method.
Figs. 6 is a plan view for explaining a semiconductor device of the embodiment and its manufacturing method.
Figs. 7 to 10 are cross-sectional views for explaining a semiconductor device of a conventional art and its manufacturing method.

### DETAILED DESCRIPTION OF THE INVENTION

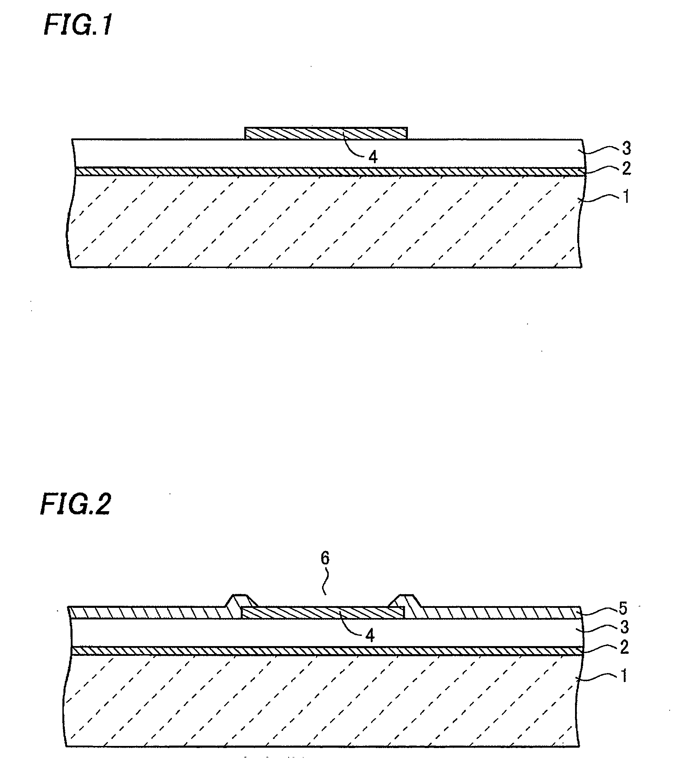

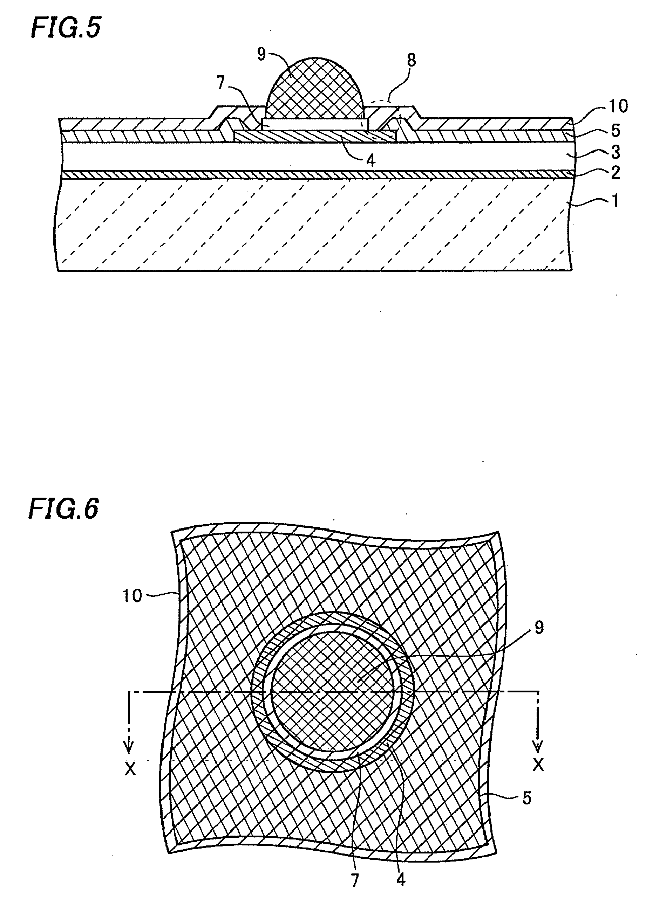

An embodiment of the invention will be described in detail referring to figures. Figs. 1 to 5 are cross-sectional views shown in process order. Fig. 6 is a plan view of a semiconductor device of the embodiment, and Fig. 5 is a cross-sectional view of Fig. 6 along line X-X. Although a MOS transistor, a plurality of wirings, an element connecting the wirings such as a plug, and an element separation film made of a silicon oxide film are formed on a semiconductor substrate as appropriate, these are not shown in the figures. A wiring extending from a pad electrode 4 is also not shown in Fig. 6.

First, an insulation film 2 (e.g. a silicon oxide film formed by a thermal oxidation method or a CVD method) is formed on a semiconductor substrate 1 made of silicon (Si) or the like to have a film thickness of, for example, 2 µm as shown in Fig. 1. An interlayer insulation film 3 (an organic film such as a polyimide type resin film) is formed on the insulation film 2 to have a film thickness of, for example, 10 µm by a coating method (by a spin coating method or a spray coating method).

Although the interlayer insulation film 3 is formed for securing a withstand voltage in this embodiment since the withstand voltage may be not secured enough if only the insulation film 2 is formed there, it is possible to form a structure without the interlayer insulation film 3 in particular. The interlayer insulation film 3 can be made of a silicon oxide film, a silicon nitride film, a PSG film, a BPSG film, or the other insulation film by a CVD method or the like.

Next, a metal layer made of aluminum (Al), copper (Cu), or the like that is to be a pad electrode 4 is formed by a CVD method, a sputtering method, or the other deposition method, and then the metal layer is patterned using a mask (not shown), thereby forming the pad electrode 4 having a film thickness of, for example, 1 µm on the interlayer insulation film 3. The pad electrode 4 is an external connection pad connected with an input circuit or an output circuit (not shown) on the semiconductor substrate.

Next, a first passivation film 5 that covers an end portion of the pad electrode 4 and has an opening 6 on the pad electrode 4 is formed to have a thickness of, for example, 10 µm as shown in Fig. 2. This first passivation film 5 is formed by coating an organic material such as a polyimide type resin film or a solder resist film on the interlayer insulation film 3 and the pad electrode 4 by a coating method and performing a heat treatment (pre-bake) thereto. It is possible to add filler (additive) to the first passivation film 5 for preventing the film from warping.

Then, exposure and development are performed to the coated organic material to form the opening 6 exposing a predetermined surface of the pad electrode 4, and a heat treatment (post-bake) is performed thereto. The first passivation film 5 covers the interlayer insulation film 3 and the end portion of the pad electrode 4. This first passivation film 5 and a second passivation film 10 that will be described below stabilize the surface of the semiconductor substrate 1 and function as protection films protecting the pad electrode 4 from corroding or the like.

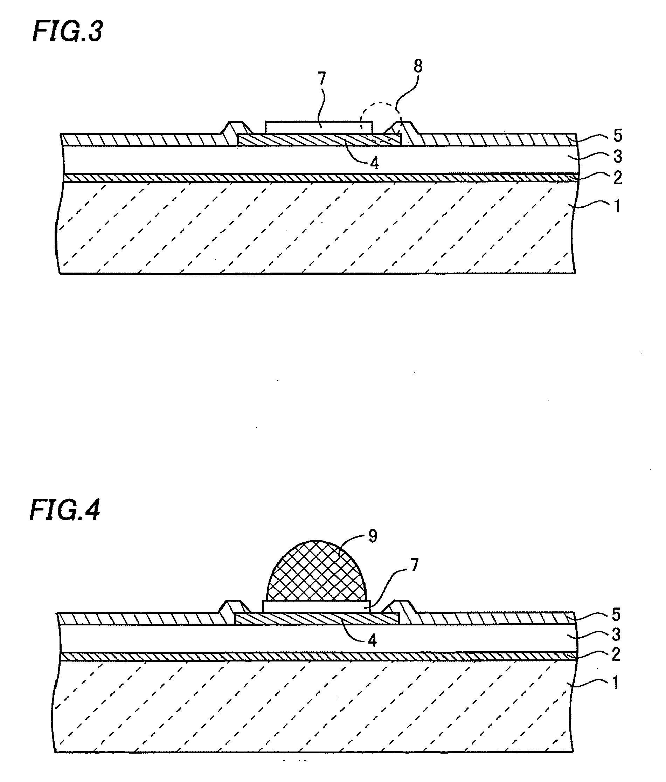

Next, a plating layer 7 is formed on the pad electrode 4 exposed in the opening 6 by layering a nickel (Ni) layer mainly made of nickel and a gold (Au) layer mainly made of gold in this order (a lower layer = a nickel layer, an upper layer = a gold layer) by an electrolytic plating method or an electroless plating method using the first passivation film 5 as a mask as shown in Fig. 3. A portion near the end portion of the pad electrode 4 is not covered with the plating layer 7, leaving an exposed portion 8. The exposed portion 8 means a portion exposing the pad electrode 4 between the first passivation film 5 and the plating layer 7.

Next, a solder ball is fixed to a predetermined region of the plating layer 7 by an electrolytic plating method using the plating layer 7 as a plating electrode, thereby forming a conductive terminal 9 as shown in Fig. 4. An advantage of forming a solder ball as the conductive terminal 9 is to facilitate its formation. The height of the conductive terminal 9 is 100 µm, for example.

It is possible to form the conductive terminal 9 by screenprinting solder and reflowing this solder by a heat treatment (solder bump). An advantage of forming a solder bump as the conductive terminal 9 is to form a fine shaped terminal with high accuracy. The conductive terminal 9 can be made of gold and its material is not particularly limited.

Next, the second passivation film 10 (a repair passivation film) made of an organic material such as a polyimide type resin film or a solder resist film is formed on the semiconductor substrate 1 by a coating method to have a thickness of, for example, 10 µm as shown in Figs. 5 and 6. The processes of the heat treatment (pre-bake, post-bake) and the exposure and development when the second passivation film 10 is formed are the same as when the first passivation film 5 is formed. The second passivation film 10 covers the exposed portion 8 of the pad electrode 4 between the plating layer 7 and the first passivation film 5. This prevents moisture, chemicals, or the like from infiltrating into the pad electrode 4 through the exposed portion 8, so that the pad electrode 4 can be prevented from corroding and thus the reliability of the semiconductor device can be enhanced. Furthermore, since the second passivation film 10 covers a portion of a sidewall of the conductive terminal 9, moisture or chemicals are prevented from infiltrating into the pad electrode 4 along the sidewall of the conductive terminal 9 and the reliability is further enhanced.

As described above, although there can be various causes of the formation of the exposed portion 8 (the influence of the filler or the adhesion state of the first passivation film 5 and the plating layer 7), this embodiment is not affected by these causes and can be broadly applied to a semiconductor device where the exposed portion 8 occurs eventually and its manufacturing method.

Although this embodiment is described as applied to the semiconductor device formed with the ball-shaped terminal 9, the structure of the embodiment can be applied to the semiconductor device without the ball-shaped terminal, for example, to a LGA (Land Grid Array) type semiconductor device.

## Claims

1. A semiconductor device comprising:
a semiconductor substrate (1);
an insulation film (2) disposed on the substrate (1);
a pad electrode (4) disposed on the insulation film (2);
a first passivation film (5) disposed on the insulation film (2) and having an opening (6) above the pad electrode (4) so that an edge portion of the pad electrode (4) is covered by the first passivation film (5);
a plating layer (7) disposed on the pad electrode (4) in the opening (6);
a conductive terminal (9) disposed on the plating layer (7) and electrically connected with the pad electrode (4); and
a second passivation film (10) disposed on the first passivation film (5) and in contact with the conductive terminal (9).

2. The semiconductor device of claim 1, wherein the second passivation film (10) is in contact with the conductive terminal (9) all around the conductive terminal.

3. The semiconductor device of claim 1 or 2, wherein the first and second passivation films (5, 10) comprise an organic material.

4. The semiconductor device according to any of claims 1 to 3, wherein the plating layer (7) comprises a nickel layer and a gold layer.

5. The semiconductor device according to any of claims 1 to 4, wherein the insulation film (2) comprises an oxide film and an interlayer insulation film (3).

6. A method of manufacturing a semiconductor device, comprising:
providing a semiconductor substrate (1) comprising an insulation film (2) disposed thereon and an pad electrode (4) disposed on the insulation film (2);
forming on the insulation film (2) a first passivation film (5) covering an edge portion of the pad electrode (4);
forming a plating layer (7) on the pad electrode (4) by an electrolytic plating method or an electroless plating method;
forming a conductive terminal (9) on the plating layer (7); and
forming on the first passivation film (5) a second passivation film (10) so as to be in contact with the conductive terminal (9) and to fill a gap between an edge portion of the plating layer (7) and an edge portion of the first passivation film (5).

7. The method of claim 6, wherein the second passivation film (10) is in contact with the conductive terminal (9) all around the conductive terminal (9).

8. The method of claim 6 or 7, wherein the first and second passivation films (5, 10)comprise an organic material.

9. The method according to any of claims 6 to 8, wherein the forming of the plating layer (7) comprises forming a nickel layer by an electrolytic plating method or an electroless plating method and forming a gold layer on the nickel layer by an electrolytic plating method or an electroless plating method.

10. The method according to any of claims 6 to 9, wherein the insulation film (2) comprises an oxide film and an interlayer insulation film (3).
